# FASCICULE DE BREVET EUROPEEN

(11) **EP 3 909 133 B1**
(45) Date de publication et mention de la délivrance du brevet: **06.03.2024**
(21) Numéro de dépôt: 20700155.3
(22) Date de dépôt: 07.01.2020
(51) Int. Cl.: H03K 17/955, H03K 17/96, B25J 13/08, B25J 19/02, F16P 3/14, G01B 7/02

(54) **PROCEDE ET DISPOSITIF DE DETECTION CAPACITIVE DISCRIMINANTE, ET EQUIPEMENT POURVU D'UN TEL DISPOSITIF**
VERFAHREN UND VORRICHTUNG ZUR DISKRIMINIERENDEN KAPAZITÄTSERFASSUNG UND MIT SOLCH EINER VORRICHTUNG AUSGESTATTETE EINRICHTUNG
METHOD AND DEVICE FOR DISCRIMINATORY CAPACITIVE DETECTION, AND APPARATUS PROVIDED WITH SUCH A DEVICE

(30) Priorité: 10.01.2019 FR 1900238
(43) Date de publication de la demande: 17.11.2021
(73) Titulaire: FOGALE SENSORS, 30900 Nimes (FR)
(72) Inventeur: ROZIERE, Didier, 30900 NÎMES (FR); NEEL, Christian, 30900 NÎMES (FR); OSSART, Frédéric, 30980 LANGLADE (FR); PORQUE, Jérôme, 34280 LA GRANDE MOTTE (FR)
(74) Mandataire: IPAZ
(86) Numéro de dépôt international: PCT/EP2020/050161
(87) Numéro de publication internationale: WO 2020/144151

(56) Documents cités:
- WO-A1-2018/134081
- US-A1- 2009 079 443

## Description

### Domaine technique

La présente invention concerne un procédé de détection capacitive discriminante d'objets se trouvant dans l'environnement d'un équipement tel qu'un robot équipé d'un dispositif de détection capacitive. Elle concerne également un dispositif de détection capacitive mettant en oeuvre un tel procédé et un équipement, notamment un robot, équipé d'un tel dispositif.

Le domaine de l'invention est, de manière non limitative, celui des dispositifs d'interaction homme-machine, et en particulier le domaine de la robotique industrielle ou des robots de service, par exemple médical ou domestique, ou encore des robots collaboratifs, également appelés « cobots ».

### Etat de la technique

Des équipements tels que des robots peuvent être équipés d'un dispositif de détection capacitive d'objets environnants, qui peuvent être des objets fixes, des objets mobiles, des êtres vivants, et en particulier un opérateur.

Un tel dispositif de détection capacitive peut comprendre des électrodes capacitives, dites électrodes de mesure, agencées sous la forme de surfaces sensibles qui recouvrent au moins partiellement la surface de l'équipement ou du robot, et une électronique de détection pour polariser les électrodes de mesure et mesurer un signal représentatif d'une capacité vue par les électrodes de mesure. A partir du signal mesuré, il est possible de détecter la présence et/ou le contact d'un objet environnant.

Cependant, les dispositifs de détection capacitive actuels, en particulier équipant les robots, ne sont pas capables de discriminer un opérateur humain de tout autre objet. De manière générale, ces dispositifs ne sont pas capables de discriminer un premier objet environnant d'un deuxième objet environnant, ces objets pouvant se trouver dans l'environnement d'un équipement ou d'un robot au même moment ou à des moments différents. Il n'est donc pas possible d'adapter, ou de personnaliser, le comportement de l'équipement ou du robot en cas de détection de tel ou tel objet environnant.

Un exemple connu de procédé de détection capacitive discriminante d'objets environnants selon le préambule de la revendication 1 est divulgué dans le document US 2009/0079443 A1.

Un but de la présente invention est de pallier ces inconvénients.

Un autre but de l'invention est de proposer une détection capacitive discriminante d'objets environnants, pour un équipement tel qu'un robot.

Il est aussi un but de la présente invention de proposer un procédé et un dispositif de détection capacitive pour un équipement tel qu'un robot, permettant de discriminer au moins un objet environnant d'au moins un autre objet, lesdits objets environnants pouvant se trouver dans l'environnement de l'équipement au même moment ou à des moments différents.

Il est aussi un but de la présente invention de proposer un procédé et un dispositif de détection capacitive pour un équipement tel qu'un robot, permettant de discriminer un opérateur d'au moins un autre objet environnant pouvant se trouver dans l'environnement de l'équipement au même moment que l'opérateur ou à des moments différents.

### Exposé de l'invention

Au moins un de ces buts est atteint avec un procédé de détection capacitive d'objets environnants pouvant se trouver dans l'environnement d'un équipement pourvu d'un dispositif de détection capacitive comprenant :
- au moins une électrode capacitive, dite de mesure ; et
- une électronique de détection pour polariser l'au moins une électrode de mesure à un potentiel électrique, et mesurer au moins un signal représentatif d'une capacité, dite électrode-objet, vue par ladite au moins une électrode de mesure ;
comprenant une étape, dite de détection discriminante, de détection sélective d'un objet environnant (102,104), comprenant les opérations suivantes :
- polarisation d'un premier objet environnant à un premier potentiel électrique alternatif, différent d'un potentiel de masse, et différent d'un potentiel électrique d'au moins un deuxième objet environnant, au moins à une première fréquence ; et
- détermination d'un premier signal discriminant représentatif d'une capacité, dite capacité électrode-objet, vue par ladite au moins une électrode de mesure, à ladite première fréquence.

Le procédé selon l'invention prévoit donc de polariser un premier objet environnant à un premier potentiel électrique qui est différent du potentiel de masse, et différent du potentiel d'au moins un deuxième objet, au moins à une première fréquence. Ainsi, on peut mettre en oeuvre une détection capacitive fonctionnant à (ou utilisant) cette première fréquence qui permet de détecter sélectivement l'un des objets, et donc de discriminer le premier objet du deuxième objet, et ce quel que soit le potentiel de polarisation des électrodes de mesure.

Par exemple, si les électrodes de mesure sont polarisées au premier potentiel, alors le premier objet sera électriquement invisible du dispositif de détection capacitive équipant l'équipement puisqu'il ne s'établit pas de différence de potentiel entre ce premier objet et les électrodes de mesure. Le deuxième objet étant polarisé à un potentiel différent du premier potentiel à la première fréquence, il s'établit une capacité entre ce deuxième objet et les électrodes de mesure, qui est vue par les électrodes de mesure à ladite première fréquence : le deuxième objet sera donc visible de manière distincte du premier objet. Dans ce cas, les électrodes de mesure seront utilisées pour réaliser une détection en « self-capacitance » et le premier signal discriminant sera représentatif de la présence ou non du deuxième objet uniquement.

Si, au contraire, les électrodes de mesure sont polarisées à un potentiel différent du premier potentiel au moins à la première fréquence, alors le premier objet sera détecté de manière sélective par les électrodes de mesure à la première fréquence, en utilisant lesdites électrodes de mesure comme électrodes réceptrices, ledit premier objet étant utilisé comme électrode émettrice. Dans ce cas, les électrodes de mesure seront utilisées pour réaliser une détection en « transmission », à la première fréquence et le premier signal discriminant sera représentatif de la présence ou non du premier objet uniquement.

Ainsi, le procédé selon l'invention propose une détection capacitive permettant de discriminer au moins un objet environnant d'au moins un autre objet, pouvant se trouver dans l'environnement d'un équipement, au même moment ou à des moments différents. Ainsi, le procédé selon l'invention permet d'adapter, voire de personnaliser, le comportement dudit équipement en fonction de l'objet détecté.

Par « objet environnant », on entend tout objet fixe, mobile, vivant ou non, pouvant se trouver dans l'environnement d'un équipement, indépendant dudit équipement. Un tel objet environnant ne fait pas partie de l'équipement et ne participe pas au fonctionnement dudit équipement, ni à celui du dispositif de détection capacitive équipant cet équipement. Il peut s'agir par exemple d'un objet se trouvant dans l'environnement de l'équipement, tel qu'un opérateur ou une personne, un convoyeur, une table ou une zone de travail, un chariot, ...

Dans le cadre de la présente invention, un « équipement » peut désigner tout type de dispositif, système, appareil, ou de sous partie d'un appareil. Il peut désigner par exemple :
- un tableau ou une interface de contrôle, un tableau de bord de véhicule, un cockpit ;
- un appareil ou une machine industrielle, telle qu'une machine d'usinage, de manipulation ou de conditionnement ;
- un système mobile, telle qu'un chariot, véhicule, véhicule autonome ;
- un robot, sous toutes ses formes, tel qu'un système robotisé, un robot mobile, un véhicule sur roues ou chenilles tel qu'un chariot muni d'un bras ou d'un système manipulateur, ou un robot de type humanoïde, gynoïde ou androïde, éventuellement pourvu d'organes de déplacement tels que des membres.

En particulier, un équipement peut être mobile lorsqu'il est en mesure de se déplacer ou qu'il comprend des parties en mouvement.

Dans la présente demande, deux potentiels alternatifs sont identiques à une fréquence donnée lorsqu'ils comportent, chacun, une composante alternative identique à cette fréquence. Ainsi, l'un au moins des deux potentiels identiques à ladite fréquence donnée peut comporter en outre une composante continue, et/ou une composante alternative de fréquence différente de ladite fréquence donnée. De même, deux potentiels alternatifs sont différents à une fréquence donnée lorsqu'ils ne comportent pas une composante alternative identique à cette fréquence

Deux composantes alternatives sont identiques lorsqu'elles sont de même fréquence, de même amplitude (par exemple à quelques pourcents près) et de même phase (par exemple à quelques degrés près). Deux composantes alternatives sont différentes lorsqu'elles ne sont pas identiques. Il peut s'agir par exemple de composantes alternatives de fréquences différentes, ou de composantes alternatives de même fréquence mais déphasées, par exemple en quadrature.

Les potentiels alternatifs mis en oeuvre dans le cadre de l'invention peuvent bien entendu être de toutes formes (sinusoïdale, carrée, triangulaire,...).

Dans la présente demande, le terme « potentiel de masse » ou « potentiel de masse générale » désigne un potentiel de référence de l'électronique, de l'équipement ou de son environnement, qui peut être par exemple un potentiel électrique d'une masse général de l'électronique. Ce potentiel de masse peut correspondre à un potentiel de terre, ou à un autre potentiel relié ou non au potentiel de terre.

De manière générale, dans la présente demande, les potentiels électriques sont définis par rapport à une référence commune, qui peut être par exemple la masse de l'électronique. Dans ce cas le potentiel de masse correspond par exemple à une valeur nulle (0V).

On rappelle par ailleurs que de manière générale, les objets qui ne sont pas en contact électrique direct avec un potentiel électrique particulier (objets électriquement flottants) tendent à se polariser par couplage capacitif au potentiel électrique d'autres objets présents dans leur environnement, tel que par exemple la terre ou des électrodes, si les surfaces de recouvrement entre ces objets et ceux de l'environnement (ou les électrodes) sont suffisamment importantes.

De manière nullement limitative, la détermination du premier signal discriminant à la première fréquence peut par exemple être réalisée en réalisant une démodulation synchrone d'un signal de mesure avec un signal de porteuse à la première fréquence, de préférence identique au premier potentiel, ou au moins de même phase.

Avec une telle démodulation synchrone, la détection sélective peut être réalisée avec un deuxième objet environnant polarisé à un potentiel électrique qui diffère du premier potentiel électrique alternatif de l'une des manières suivantes :
- il ne comprend pas de composante à la première fréquence ;
- il comprend une composante à la première fréquence, mais uniquement en quadrature de phase avec le premier potentiel à cette première fréquence. Dans ce cas, il est en effet possible de distinguer ou de sélectionner avec la démodulation synchrone les composantes en phase et en quadrature du signal de mesure global.

La détermination du premier signal discriminant à la première fréquence peut également être réalisée avec un démodulateur asynchrone, ou une détection d'enveloppe, avec par exemple un redressement d'un signal de mesure filtré passe-bande autour de la première fréquence suivi d'un filtrage passe-bas.

Avec une telle détection d'enveloppe, la détection sélective peut être réalisée avec un deuxième objet environnant polarisé à un potentiel électrique qui diffère du premier potentiel électrique alternatif en ce qu'il ne comprend pas de composante à la première fréquence.

Il est à noter que dans tous les cas, pour l'étape de détection sélective, le potentiel électrique du deuxième objet doit différer du premier potentiel électrique alternatif dans le sens où il ne comprend pas de composantes indiscernables du premier potentiel électrique alternatif pour l'électronique de détection mise en oeuvre.

Le procédé selon l'invention peut comprendre, pendant l'étape de détection discriminante, une polarisation d'au moins un deuxième objet au potentiel de masse.

Alternativement ou en plus, le procédé selon l'invention peut comprendre, pendant l'étape de détection discriminante, une polarisation d'au moins un deuxième objet à un deuxième potentiel alternatif à une deuxième fréquence différente de la première fréquence.

Dans ce cas, il est possible de réaliser une détection individuelle de ce deuxième objet, de manière isolée des autres objets, en déterminant un deuxième signal discriminant représentatif de la capacité électrode-objet vue par l'au moins une électrode de mesure à cette deuxième fréquence. En effet, dans ce cas, le deuxième signal discriminant sera représentatif de la présence ou non du deuxième objet uniquement, indépendamment de la présence ou non du premier objet (pour autant bien entendu que le premier potentiel électrique alternatif ne comprenne pas de composantes indiscernables à la deuxième fréquence).

De manière nullement limitative, la détermination du deuxième signal discriminant à la deuxième fréquence peut par exemple être réalisée en réalisant une démodulation synchrone d'un signal de mesure avec un signal de porteuse à la deuxième fréquence, ou identique au deuxième potentiel à la deuxième fréquence.

Alternativement, ou en plus, le procédé selon l'invention peut comprendre, pendant l'étape de détection discriminante, une polarisation d'au moins un deuxième objet à un potentiel de même fréquence que le premier potentiel alternatif et orthogonal audit premier potentiel alternatif, à ladite première fréquence.

Les potentiels sont dits orthogonaux, ou orthogonaux au sens du produit scalaire, lorsque leur produit scalaire, ou la somme des produits de leurs valeurs temporelles successives, est nulle, au moins au niveau de bruit près.

Ces potentiels peuvent bien entendu être de toute forme d'onde (sinusoïdale, carrée, triangulaire ...)
Des exemples de potentiels orthogonaux comprennent par exemple des potentiels de fréquences (ou de fréquences fondamentales) différentes non multiples l'une de l'autre, et des potentiels de même fréquence (ou de même fréquence fondamentale) en quadrature de phase.

Ainsi, dans ce cas, chacun des premiers et deuxièmes objets sont polarisés à des potentiels comportant une composante à la première fréquence. Cependant, ces composantes sont orthogonales entre-elles, de sorte qu'elles peuvent être discriminées pour la détection capacitive, conformément à la définition donnée plus haut. Il est alors possible de réaliser une détection de chacun des premiers et deuxièmes objets, de manière individuelle, lors de l'étape de détection discriminante.

Les potentiels ou leurs composantes orthogonales peuvent être en quadrature de phase. La détection capacitive peut mettre en oeuvre comme expliqué précédemment une démodulation synchrone avec au moins un signal de porteuse en phase avec le premier potentiel alternatif pour détecter la composante correspondante, et éventuellement aussi un signal de porteuse en quadrature avec le premier potentiel alternatif pour détecter la composante orthogonale.

Lorsque l'étape de détection discriminante comprend une détection individuelle ou sélective d'un premier objet et une détection individuelle ou sélective d'un deuxième objet, ces détections individuelles peuvent être réalisées :
- de manière simultanée ou à tour de rôle, à partir d'un même signal mesuré ; ou
- à tour de rôle, à partir de deux signaux mesurés séquentiellement.

Suivant un mode de réalisation, pendant l'étape de détection discriminante, l'au moins une électrode de mesure peut être polarisée au potentiel de masse.

Dans ce cas, la détection capacitive est une détection en transmission en utilisant la ou les électrodes de mesure comme électrodes réceptrices, et le(s) objet(s) comme électrode(s) émettrice(s).

Dans ce mode de réalisation, il est possible de réaliser une détection individuelle du premier objet, mais aussi d'au moins un deuxième objet, comme décrit plus haut, de manière simultanée ou à tour de rôle.

Alternativement, l'au moins une électrode de mesure peut être polarisée à un troisième potentiel alternatif.

Dans ce cas, le potentiel de l'au moins une électrode de mesure est donc différent du potentiel de masse, et comprend au moins une composante alternative à au moins une fréquence.

Suivant un exemple de réalisation nullement limitatif du procédé selon l'invention, pendant l'étape de détection discriminante, le troisième potentiel de polarisation peut être :
- différent du premier potentiel de polarisation à la première fréquence, et
- le cas échéant, différent du deuxième potentiel de polarisation à la deuxième fréquence.

Autrement dit, comme expliqué précédemment, le troisième potentiel de polarisation ne comprend pas de composantes indiscernables du premier et/ou du deuxième potentiel électrique alternatif pour l'électronique de détection mise en oeuvre.

Par exemple, avec une démodulation synchrone, on peut utiliser un troisième potentiel orthogonal au sens du produit scalaire au premier potentiel de travail, en particulier à la première fréquence de travail, et/ou de fréquence différente. Avec une détection d'enveloppe, on peut utiliser un troisième potentiel de fréquences différentes de la première fréquence de travail.

Les mêmes raisonnements s'appliquent avec le deuxième potentiel de travail à la deuxième fréquence.

Dans ce cas, lors de l'étape de détection discriminante, l'au moins une électrode de mesure est utilisée comme électrode réceptrice dans le cadre d'une détection capacitive en transmission avec une détection :
- à la première fréquence pour la détection individuelle du premier objet, et
- le cas échéant, à la deuxième fréquence pour la détection individuelle du deuxième objet ;
de manière simultanée ou à tour de rôle.

Par exemple, le troisième potentiel peut ne pas comprendre de composante alternative à la première fréquence, et le cas échéant, à la deuxième fréquence.

Alternativement, le troisième potentiel peut être identique au premier potentiel de polarisation à la première fréquence, ou au deuxième potentiel de polarisation à la deuxième fréquence.

Par exemple, le troisième potentiel peut être identique au premier potentiel à la première fréquence. Dans ce cas, le premier objet devient invisible et le deuxième objet génère une capacité vue par les électrodes de mesure en mode self-détection, à la première fréquence.

Alternativement, le troisième potentiel peut être identique au deuxième potentiel à la deuxième fréquence. Dans ce cas, le deuxième objet devient invisible et le premier objet peut être détecté en mode transmission, à la première fréquence.

Le procédé selon l'invention peut en outre comprendre une étape, dite de détection commune, de détection des objets environnants, comprenant les opérations suivantes :
- polarisation d'au moins une électrode de mesure à un potentiel alternatif, dit de travail, différent d'un potentiel de masse, et différent des potentiels des premier et deuxième objets environnants au moins à une fréquence, dite de travail ; et
- détermination d'un signal commun, représentatif d'une capacité, dite capacité électrode-objet, vue par l'au moins une électrode de mesure, à ladite fréquence de travail.

Ainsi, le signal commun est représentatif de la capacité due à la présence du premier objet, ou à la présence du deuxième objet, ou encore à la présence de ces deux objets, sans pouvoir discriminer le ou les objets présents. Autrement dit, le signal commun est représentatif de la présence ou non d'au moins un des objets sans possibilité de discrimination desdits objets.

Suivant un mode de réalisation particulier nullement limitatif, lors de l'étape de détection commune :
- la fréquence de travail peut être identique à la première fréquence, et le potentiel de travail peut être identique, à cette fréquence, au premier potentiel de polarisation d'un premier objet lors de l'étape de détection discriminante, ou
- le cas échéant, la fréquence de travail peut être identique à la deuxième fréquence et le potentiel de travail peut être identique, à cette fréquence, au deuxième potentiel de polarisation d'un deuxième objet ;
les étapes de détection discriminante et commune étant réalisées de manière séquentielle, ledit procédé comprenant une étape de modification du potentiel dudit premier objet, ou dudit deuxième objet, entre lesdites étapes de détection.

Dans ce cas, les étapes de détection discriminante et de détection commune sont réalisées à tour de rôle.

De plus, l'étape de détection discriminante comprend une mesure d'un signal électrique à partir duquel est déterminé le premier signal de détection discriminante, et l'étape de détection commune comprend une autre mesure d'un signal électrique à partir duquel est déterminé le signal de détection commune.

Suivant un autre mode de réalisation, le potentiel de travail utilisé lors de l'étape de détection commune, peut être différent :
- des potentiels de polarisation des objets utilisés lors de l'étape de détection discriminante, à la première fréquence ; et
- le cas échéant, du deuxième potentiel à la deuxième fréquence.

Dans ce cas, les étapes de détection discriminante et de détection commune peuvent être réalisées de manière simultanée de sorte que le signal commun et le(s) signal(signaux) discriminant, sont déterminés à partir d'un même signal mesuré. Ainsi, le procédé selon l'invention permet de réaliser une détection plus rapide, à partir d'un même signal mesuré.

Alternativement, dans ce mode de réalisation, les étapes de détection discriminante et de détection commune peuvent aussi être réalisées de manière séquentielle à partir de signaux de mesure différents.

Suivant un premier exemple de ce mode de réalisation, la fréquence de travail peut être la première fréquence, mais, à cette fréquence, le potentiel de travail peut être orthogonal à chacun des potentiels de polarisation utilisés pour polariser les objets à cette première fréquence.

Suivant un autre exemple de ce mode de réalisation, la fréquence de travail peut être la deuxième fréquence, mais, à cette fréquence, le potentiel de travail peut être orthogonal au deuxième potentiel, et plus généralement à chacun des potentiels de polarisation utilisés pour polariser les objets à cette deuxième fréquence.

Suivant encore un autre exemple, le potentiel de travail utilisé lors de l'étape de détection commune, peut-être de fréquence différente de la première fréquence, et le cas échéant de la deuxième fréquence.

Le procédé selon l'invention prévoit donc de polariser, au moins le premier objet, à un potentiel différent d'un potentiel de masse à la première fréquence.

Pour ce faire, au moins un objet environnant peut être polarisé de manière filaire à partir d'une source alimentant le dispositif de détection capacitive utilisé dans le procédé selon l'invention.

Alternativement ou en plus, au moins un objet environnant peut être polarisé par une source électrique indépendante d'une source électrique alimentant le dispositif de détection.

Dans ce cas, le procédé selon l'invention peut comprendre un échange, entre lesdites sources, d'un signal sans fil pour :
- synchroniser lesdites sources entre-elles ; ou
- récupérer la fréquence, et/ou la phase, du signal de polarisation dudit au moins un objet environnant.

Un tel signal sans fil peut être échangé par toute connexion sans fil utilisant tous types de protocoles de communication.

Par exemple un tel signal sans fil peut être échangé par une connexion Bluetooth, WIFI ou plus généralement par toute connexion radio.

Avantageusement, l'un au moins des objets environnants peut être un corps ou une partie d'un corps d'un opérateur humain.

Ainsi, il est possible de détecter la présence ou non d'un opérateur indépendamment de la présence ou non d'un autre objet.

Il alors possible de prévoir au niveau de l'équipement un comportement spécifique en cas de détection d'un opérateur, et un comportement différent en cas de détection d'un autre objet. En particulier, il est possible d'adopter un comportement spécifique optimisant la sécurité de l'opérateur puisqu'il est possible de détecter l'opérateur en le discriminant d'un autre, et en particulier de tout autre, objet environnant.

Suivant un exemple de réalisation, le premier objet peut être au moins une partie d'un corps d'un opérateur humain, et en particulier une main ou un bras dudit opérateur.

L'opérateur humain, ou la partie du corps de l'opérateur humain, peut être polarisé(e) par un ou plusieurs contacts électriques équipant au moins :
- un bracelet porté par l'opérateur,
- un vêtement porté par l'opérateur,
- une chaussure portée par l'opérateur,
- etc.

Alternativement, le premier objet peut également être une surface de travail faisant face à l'équipement telle qu'une table, un plan de travail, un tapis roulant, et le deuxième objet est au moins une partie d'un corps d'un opérateur humain.

Le procédé selon l'invention peut en outre comprendre une étape de déclenchement :
- d'au moins une première commande, préalablement associée au premier objet, en cas de détection du premier objet lors de l'étape de détection discriminante ; et
- d'au moins une deuxième commande, préalablement associée au deuxième objet, différente de ladite première commande, en cas de détection du deuxième objet lors de l'étape de détection discriminante.

Par exemple, lorsqu'un des objets est un opérateur, la commande qui lui est associée peut être une procédure d'urgence ou un arrêt de l'équipement, lorsque celui-ci est mobile ou comprend des parties mobiles (tel qu'un robot).

Toujours suivant un exemple non limitatif, lorsqu'un des objets est un objet autre qu'un opérateur, la commande qui lui est associée peut être un ralentissement ou un changement de trajectoire d'un équipement mobile ou d'une partie mobile d'un équipement.

Bien entendu, le procédé selon l'invention peut permettre la détection sélective d'une pluralité de premiers objets en présence d'un ou d'une pluralité de seconds objets. Il est ainsi possible par exemple d'appliquer respectivement des premiers potentiels alternatifs différents entre eux à des premiers objets environnants distincts, et de les détecter sélectivement et individuellement selon l'invention.

Il est ainsi par exemple possible de polariser des opérateurs différents à différentes premières fréquences et de les identifier. Les premiers objets détectés individuellement peuvent également comprendre des opérateurs et d'autres éléments de l'environnement, tels que des éléments mobiles, chariots, plans de travail, ...

Par ailleurs, le deuxième objet peut désigner tout élément de l'environnement de l'équipement ou du robot (sol, convoyeur, opérateur ...), par exemple à la masse ou à la terre.

Suivant un autre aspect de l'invention, il est proposé un dispositif de détection capacitive, pour un équipement, comprenant :
- au moins une électrode capacitive, dite de mesure ; et
- une électronique de détection pour polariser au moins une électrode de mesure, et mesurer au moins un signal représentatif d'une capacité, dite électrode-objet, vue par ladite au moins une électrode de mesure ; et
- un moyen de polarisation d'au moins un objet environnant ;
agencés pour mettre en oeuvre toutes les étapes du procédé selon l'invention.

En particulier, l'électronique de détection capacitive peut être configurée pour mettre en oeuvre individuellement, ou en combinaison, chacune des étapes ou opérations décrites plus haut en référence au procédé selon l'invention, et qui ne sont pas reprises ici par soucis de concision.

Le moyen de polarisation d'au moins un objet environnant peut comprendre au moins un contact électrique véhiculant un potentiel de polarisation audit objet, depuis une source électrique.

Lorsque l'objet environnant est un corps humain, ou une partie du corps humain, le moyen de polarisation peut comprendre au moins un contact électrique disposé dans au moins un :
- un bracelet porté par l'opérateur,
- un vêtement porté par l'opérateur,
- une chaussure portée par l'opérateur,
- etc.

Le dispositif selon l'invention peut comprendre une source électrique commune pour alimenter l'électronique de détection et polariser au moins un objet environnant.

Dans ce cas, ledit objet environnant est relié à l'électronique de détection de manière filaire.

Alternativement ou en plus, le dispositif selon l'invention peut comprendre :
- une première source électrique pour polariser le premier objet ; et
- une deuxième source pour alimenter l'électronique de détection, indépendante de ladite première source.

Dans ce cas, la première source électrique peut être en communication, filaire ou sans fil, avec l'électronique de détection pour transmettre, et/ou recevoir, un signal de synchronisation du potentiel de polarisation qu'il fournit à l'objet environnant.

Le signal échangé peut être utilisé, côté objet environnant, pour assurer une polarisation correcte de l'objet environnant.

Le signal échangé peut être utilisé, côté électronique de détection, pour déterminer un signal discriminant, et plus particulièrement pour être utilisé comme, ou pour générer une porteuse pour une démodulation synchrone d'un signal mesuré par l'électronique de détection lors de la phase de détection discriminante.

Suivant un mode de réalisation alternatif, le dispositif selon l'invention peut comprendre une unique source électrique pour la polarisation, à tour de rôle :
- d'au moins un objet environnant, et
- des électrodes de mesure ;
ledit dispositif comprenant en outre des moyens de connexion/déconnexion à tour de rôle de ladite source audit objet environnant et auxdites électrodes de mesure.

Les moyens de connexion/déconnexion peuvent comprendre des commutateurs commandés.

La commutation peut être réalisée entre une étape de détection discriminante lors de laquelle la source polarise un objet environnant, et une étape de détection commune lors de laquelle la source polarise les électrodes de mesure.

Le dispositif de détection peut en outre comprendre au moins une électrode de garde pour garder électriquement l'au moins une électrode de mesure.

Dans ce cas, l'au moins une électrode de garde est polarisée au même potentiel que les électrodes de mesure, ou au même potentiel que les électrodes de mesure à la fréquence de détection, le cas échéant.

L'électronique de détection peut être réalisée avec des composants analogiques, ou numériques ou encore par une combinaison de composants analogiques et de composants numériques.

Suivant un exemple de réalisation, l'électronique de détection capacitive peut comprendre un étage de mesure comprenant un amplificateur opérationnel (AO), ou un circuit réalisant un amplificateur opérationnel, fonctionnant en amplificateur de transimpédance ou de charge, dont :
- une première entrée, par exemple inverseuse, est reliée à une ou des électrodes de mesure, directement ou par l'intermédiaire d'un moyen de scrutation par exemple ;
- une deuxième entrée, par exemple non inverseuse, reliée au potentiel de polarisation des électrodes de mesure, et le cas échant de garde.

La sortie de l'AO est rebouclée sur ladite première entrée par l'intermédiaire d'une impédance, et en particulier d'une capacité.

Dans cette configuration, la sortie de l'AO fournit une tension Vₛ dont l'amplitude est proportionnelle à la capacité électrode-objet entre au moins une électrode de mesure et l'objet.

L'électronique de détection peut en outre comprendre un oscillateur fournissant un potentiel alternatif de polarisation des électrodes de mesure, et le cas échéant de l'au moins une électrode de garde.

Ce potentiel de polarisation peut comprendre un signal sinusoïdal, ou carré, ou de toute autre forme d'onde. La fréquence de détection peut correspondre à la fréquence fondamentale de cette forme d'onde.

L'électronique de détection peut comprendre au moins un étage d'analyse pour déterminer un signal de détection, à partir de la tension Vₛ fournie par l'étage de mesure, à une fréquence de détection, à savoir soit la première fréquence, soit la deuxième fréquence, soit la fréquence de travail.

Cet étage d'analyser peut comprendre un démodulateur (synchrone ou asynchrone) à la fréquence de détection, ou un détecteur d'amplitude, un module de calcul, etc.

L'électronique de détection peut comprendre un unique étage d'analyse utilisé à tour de rôle pour déterminer chaque signal de détection, à savoir le premier signal de détection discriminante, le cas échéant le deuxième signal de détection discriminante, et le signal de détection commune.

Alternativement, l'électronique de détection peut comprendre plusieurs étages d'analyse, chacun, dédié à la détermination d'un signal de détection, à savoir :
- un premier étage d'analyse pour déterminer le premier signal de détection discriminante,
- le cas échéant, un deuxième étage d'analyse pour déterminer le deuxième signal de détection discriminante, et
- un troisième étage d'analyse pour déterminer le signal de détection commune.

Le ou chaque étage d'analyse peut être un étage analogique, ou numérique, un étage physique ou un étage logiciel. Par ailleurs, ces étages d'analyse peuvent être agencés en série ou en parallèle.

Suivant un autre aspect de la même invention, il est proposé un équipement pourvu d'un dispositif de détection capacitive selon l'invention.

Suivant des exemples de réalisation nullement limitatifs, l'équipement peut être de type robot, ou comprendre tout système robotisé.

Comme expliqué précédemment, il peut en particulier se présenter sous la forme de, ou comprendre, un bras robotisé.

Le robot peut également être, ou comprendre, par exemple un robot mobile, un véhicule sur roues ou chenilles tel qu'un chariot muni d'un bras ou d'un système manipulateur, ou un robot de type humanoïde, gynoïde ou androïde, éventuellement pourvu d'organes de déplacement tels que des membres.

### Description des figures et modes de réalisation

D'autres avantages et caractéristiques apparaîtront à l'examen de la description détaillée d'exemples nullement limitatifs, et des dessins annexés sur lesquels :
- la FIGURE 1 est une représentation schématique d'un exemple de réalisation non limitatif d'un dispositif de détection capacitive pouvant être utilisé dans la présente invention ;
- la FIGURE 2a est une représentation schématique d'un exemple permettant de réaliser une étape de détection capacitive discriminante ;
- la FIGURE 2b est une représentation schématique d'un exemple permettant de réaliser une étape de détection capacitive commune ;
- la FIGURE 3a est une représentation schématique d'un exemple permettant de réaliser une étape de détection capacitive discriminante ;
- la FIGURE 3b est une représentation schématique d'un autre exemple permettant de réaliser une étape de détection capacitive discriminante ;
- la FIGURE 4 est une représentation schématique d'un autre exemple permettant de réaliser une étape de détection capacitive discriminante et une étape de détection commune ;
- les FIGURES 5a et 5b sont des représentations schématiques, dans deux configurations, d'un exemple permettant de réaliser une étape de détection capacitive discriminante et une étape de détection commune, avec une seule source électrique ;
- la FIGURE 6 est une représentation schématique d'un autre exemple permettant de réaliser une étape de détection capacitive discriminante ; et
- les FIGURES 7a et 7b sont des représentations schématiques, dans deux configurations, d'un autre exemple permettant de réaliser une étape de détection capacitive discriminante et une étape de détection commune, avec une seule source électrique.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

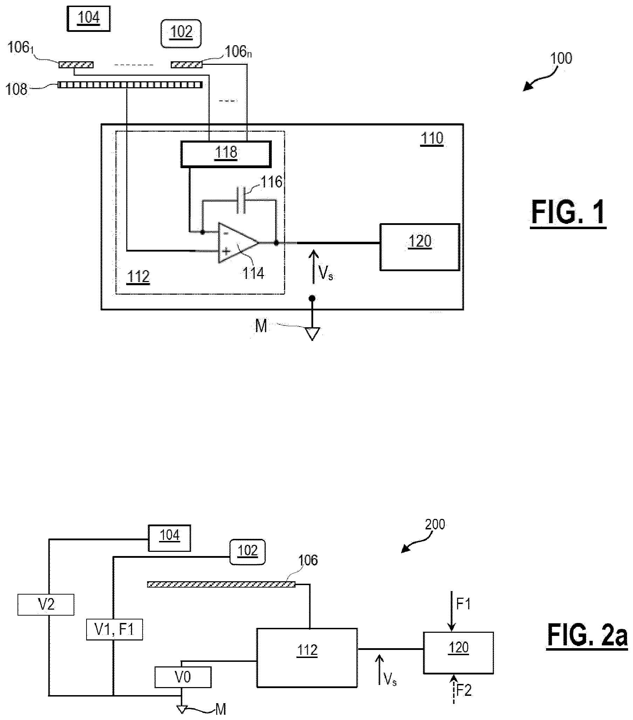

La FIGURE 1 est une représentation schématique d'un exemple de réalisation non limitatif d'un dispositif de détection capacitive pouvant être mis en oeuvre dans la cadre de la présente invention.

Le dispositif 100, représenté sur la FIGURE 1, peut être réalisé sous une forme analogique ou numérique, ou une combinaison de composants analogiques et de composants numériques.

La FIGURE 1 représente également un premier objet environnant 102 et un deuxième objet environnant 104 que le dispositif 100 permet de détecter, et qui ne font pas partie d'un équipement, tel qu'un robot, équipé par le dispositif de détection 100.

Pour détecter les objets environnants 102-104, le dispositif de détection capacitive 100 comporte plusieurs électrodes capacitives 106₁-106ₙ, dites électrodes de mesure, permettant de mesurer une grandeur électrique, et en particulier une tension, représentative d'une capacité, dite électrode-objet, formée entre d'une part une ou plusieurs des électrodes de mesure 106₁-106ₙ et d'autre part le ou les objets 102 et 104. Dans la suite, les références 106 ou 106ᵢ peuvent être utilisées pour désigner les électrodes de mesure.

Le dispositif 100 comporte également, de manière optionnelle, au moins une électrode 108, dite de garde, pour garder électriquement les électrodes de mesure 106. Pour ce faire, cette électrode de garde 108 est mise au même potentiel électrique que les électrodes de mesure 106, au moins à la fréquence de détection de l'électronique.

Le dispositif de détection 100 comporte également une électronique de détection 110 pour :
- polariser au moins une électrode de mesure 106 à un potentiel électrique, qui peut être un potentiel de masse ou un potentiel différent du potentiel de masse, tel qu'un potentiel alternatif, et
- mesurer au moins un signal représentatif d'une capacité, dite électrode-objet, vue par ladite au moins une électrode de mesure 106.

Pour ce faire, l'électronique de détection 110 comprend un étage de mesure 112.

L'étage de mesure 112 comprend un amplificateur de courant, ou de charge, représenté par un amplificateur opérationnel (AO) 114 et une capacité de contre-réaction 116 rebouclant la sortie de l'AO 114 à l'entrée inverseuse « - » de l'AO 114.

De plus, dans l'exemple représenté, l'entrée non-inverseuse « + » de l'AO 112 reçoit le potentiel de polarisation des électrodes de mesure 106 et de l'électrode de garde 108 et l'entrée inverseuse « - » de l'AO 112 est prévue pour être reliée à chaque électrode de mesure 106ᵢ par l'intermédiaire d'un moyen de scrutation 118 de sorte à interroger individuellement à tour de rôle les électrodes de mesure 106.

Le moyen de scrutation 118 est, bien entendu, optionnel et peut être par exemple un switch.

Dans ces conditions, l'amplificateur de charge, et en particulier l'AO 114, fournit en sortie une tension V_{S}, à la fréquence de détection et d'amplitude proportionnelle à la capacité de couplage Cₑₒ, dite capacité électrode-objet, entre une ou plusieurs électrodes de mesure 106 reliée à son entrée « - » et le ou les objets à proximité, ou en contact, de ladite électrode de mesure 106. La tension V_{S} est mesurée, dans l'exemple illustré, par rapport à un potentiel de masse, référencé M.

De manière générale, l'étage de mesure 112 peut être analogique et/ou numérique (microprocesseur) et comprendre tous moyens nécessaires de filtrage, de conversion, de traitement, etc. L'étage de mesure 112 peut en outre comprendre d'autres composants que ceux décrits.

L'électronique de détection 100 peut en outre comprendre un étage d'analyse 120, prévu pour analyser le signal V_{S} et en déduire un signal de détection capacitive.

L'étage d'analyse 120 peut comprendre :
- un démodulateur (synchrone ou asynchrone) pour démoduler le signal fourni par l'étage de mesure 112 à une fréquence de détection,
- un détecteur d'amplitude pour mesurer l'amplitude du signal fourni par le démodulateur ; et
- un module de calcul pour fournir un signal relatif à la présence, et ou au contact, d'un ou plusieurs objets environnants.

Comme expliqué précédemment, le démodulateur peut donc comprendre un démodulateur synchrone. Dans ce cas, le signal de mesure issu de l'étage de mesure 112 est éventuellement filtré passe-bande, puis multiplié par un signal de porteuse à la fréquence de détection, de préférence en phase avec le signal de mesure, puis filtré passe-bas pour obtenir un signal d'amplitude.

Le démodulateur peut également comprendre un démodulateur asynchrone, ou une détection d'enveloppe, avec par exemple un redressement du signal de mesure filtré passe-bande autour de la fréquence de détection suivi d'un filtrage passe-bas.

Le module de calcul peut être agencé pour déterminer une distance ou une information de distance, et/ou un contact ou une information de contact, entre au moins une électrode de mesure 106 et au moins un objet. Le module de calcul peut par exemple comprendre ou être réalisé sous la forme d'un microcontrôleur, ou d'un FPGA. Le module de calcul peut également fournir d'autres informations, telles que des déclenchements d'alarmes ou de procédures de sécurité, lorsque par exemple les distances mesurées sont inférieures à des seuils de distance prédéterminés.

Sur la FIGURE 1, seul un étage d'analyse est représenté. Bien entendu, l'électronique de détection peut comprendre plusieurs étages d'analyse utilisés simultanément ou à tour de rôle, pour la même fréquence détection ou pour des fréquences de détection différentes.

De manière générale, l'étage d'analyse 120 peut être analogique et/ou numérique (microprocesseur) et comprendre tous moyens nécessaires de filtrage, de conversion, de traitement, etc. L'étage d'analyse 120 peut en outre comprendre d'autres composants que ceux décrits.

L'électronique de détection 110, ou au moins sa partie sensible avec l'amplificateur de charge peut être référencée (ou alimentée par des alimentations électriques référencées) à un même potentiel que l'électrode de garde pour minimiser les capacités parasites, en particulier lorsque ce potentiel est alternatif et/ou différent du potentiel de masse M. L'électronique de détection 100 peut également être référencée, de manière plus classique, au potentiel de masse M.

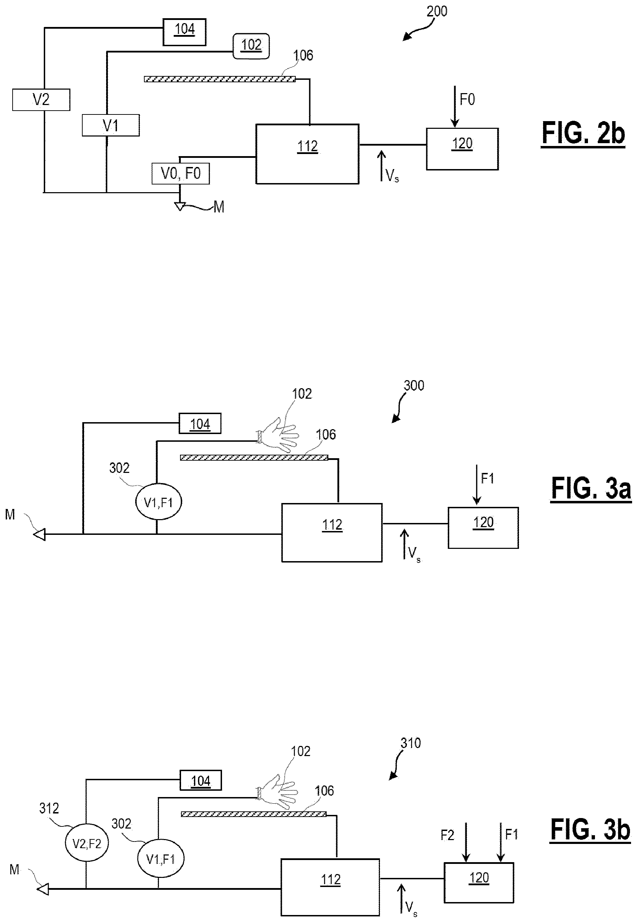

Les FIGURES 2a et 2b sont des représentations schématiques, dans deux configurations, d'un exemple général pour réaliser une étape de détection capacitive discriminante et une étape de détection capacitive commune.

La FIGURE 2a représente la configuration réalisant l'étape détection capacitive discriminante et la FIGURE 2b représente la configuration réalisant l'étape détection commune.

Dans l'exemple 200 représenté sur les FIGURES 2a et 2b :
- l'électrode de mesure 106 est portée à un potentiel V0,
- le premier objet environnant 102 est porté à un potentiel alternatif V1 de fréquence F1, et
- le deuxième objet environnant 104 est porté à un potentiel V2.

En référence à la FIGURE 2a, une étape de détection discriminante d'un des objets environnants peut être réalisée à la fréquence F1, non nulle, pour autant que les potentiels V1 et V2 soient différents à la fréquence F1 et que le potentiel V1 soit différent du potentiel de masse M.

Suivant un premier cas, si les potentiels V1 et V0 sont identiques ou sensiblement identiques à la fréquence F1, alors V1 et V0 ont (sensiblement) la même phase et la même amplitude à la fréquence F1. Dans ce cas, le premier objet 102 sera au même potentiel que l'électrode de mesure à la fréquence F1. La détection capacitive à la fréquence F1 détectera uniquement l'objet 104 car l'objet 102 sera électriquement invisible pour l'électrode de mesure 106, car étant au même potentiel. La détection capacitive sera alors une détection capacitive en self-capacitance.

Suivant un deuxième cas, si les potentiels V1 et V0 sont différents à la fréquence F1, alors la détection capacitive à la fréquence F1 détectera uniquement l'objet 102, pour autant bien entendu que le potentiel V0 et le potentiel V2 ne génèrent pas de composantes mesurables (au moins significatives) par le démodulateur à la fréquence F1, soit notamment, pas de composantes à la fréquence F1, ou, avec un détecteur synchrone uniquement, pas de composante en phase avec le potentiel V1 à la fréquence F1. La détection capacitive sera alors une détection capacitive en transmission, utilisant l'objet 102 comme électrode émettrice et l'électrode de mesure 106 comme électrode réceptrice. Dans ce cas, le potentiel V0 peut être égal ou différent du potentiel de masse M. Par ailleurs, le potentiel V2 peut être égal ou différent du potentiel de masse M, et/ou égal ou différent du potentiel V0.

Suivant un troisième cas, si le potentiel V1 est différent de V0 à la fréquence F1, et que le potentiel V2 est un potentiel alternatif à une fréquence F2, également différent de V0, alors la détection capacitive à la fréquence F1 détectera uniquement l'objet 102. En plus, il sera possible de réaliser une détection capacitive à la fréquence F2 qui détectera uniquement l'objet 104. La détection capacitive sera alors une détection capacitive en transmission, utilisant l'objet 102 comme électrode émettrice et l'électrode de mesure 106 comme électrode réceptrice. Cela est possible avec un démodulateur synchrone ou asynchrone, et des fréquences F1 et F2 différentes. Cela est également possible avec un démodulateur synchrone fonctionnant en phase et en quadrature, avec un potentiel V2 de même fréquence mais en quadrature de phase avec V1 à la fréquence F1 (ou F2).

En référence à la FIGURE 2b, en appliquant un potentiel alternatif V0 de fréquence F0 à l'électrode de mesure 106, l'ensemble des objets 102 et 104 peuvent être détectés, sans discrimination, avec une démodulation à la fréquence F0, pour autant que les potentiels V0 et V1, respectivement V0 et V2 soient différents à F0. Comme précédemment ces conditions sont remplies si les potentiels V1 et V2 ne génèrent pas de composantes mesurables (au moins significatives) par le démodulateur à la fréquence F0, soit notamment, pas de composantes à la fréquence F0, ou, avec un détecteur synchrone uniquement, pas de composante en phase avec le potentiel V0 à la fréquence F0.

En particulier, il est possible d'avoir les potentiels V1 et V2 égaux ou sensiblement égaux au potentiel de masse M pour l'étape de détection commune.

La fréquence F0 peut être différente de la fréquence de V1 et V2, ce qui permet la mise en oeuvre de démodulations synchrones ou asynchrones.

Alternativement, avec une démodulation synchrone, V0 peut être de même fréquence que V1, respectivement V2, mais en quadrature de phase avec V1, respectivement V2.

A partir des cas décrits ci-dessus, on peut déduire que dans le cas où les potentiels V1, V2 et V0 sont tous différents, il est possible de réaliser :
- d'une part une étape de détection discriminante d'objets environnants détectant individuellement l'objet 102 avec une démodulation à F1, et l'objet 104 avec une démodulation à F2 ; et
- d'autre part une étape de détection commune des objets, détectant tous les objets présents sans discrimination, avec une démodulation à F0.

De plus, ces étapes peuvent être réalisées simultanément ou à tour de rôle.

V0, V1 et V2 peuvent être de fréquences différentes, avec une démodulation synchrone ou asynchrone.

Alternativement, l'une au moins des potentiels V0, V1 et V2 peut être de même fréquence mais en quadrature de phase avec au moins un des autres potentiels V0, V1 et V2, avec une démodulation synchrone.

Nous allons maintenant décrire des exemples de réalisation particuliers, en référence aux FIGURES 3a à 5b. Sur ces FIGURES, et de manière nullement limitative, on considère que le premier objet environnant 102 est une main d'un opérateur et le deuxième objet environnant 104 est tout autre objet pouvant se trouver dans l'environnement de l'équipement, qui est dans le cas illustré un robot, tel qu'une table, un support, un plan de travail, un autre robot, etc.

La FIGURE 3a est une représentation schématique d'un exemple de réalisation pour réaliser une étape de détection capacitive discriminante.

En particulier, l'exemple 300 représenté en FIGURE 3a, permet de réaliser une détection capacitive discriminante de la main 102 (qui correspond au premier objet environnant 102).

Pour ce faire, la main 102 est polarisée à un potentiel V1, de fréquence F1, différent du potentiel de masse M, délivré par une source électrique 302.

Le deuxième objet 104 et l'électrode capacitive 106 sont polarisés au potentiel de masse M.

Cet exemple 300 permet de réaliser une étape détection capacitive discriminante pour détecter, à la fréquence F1, la présence ou l'absence de la main 102. La détection réalisée est une détection en transmission utilisant la main 102 comme électrode émettrice et l'électrode de mesure 106 comme électrode réceptrice.

Cet exemple 300 ne permet, par contre, pas de réaliser une étape de détection capacitive commune, à savoir une étape de détection, sans discrimination, de l'un quelconque des objets 102 et 104.

La FIGURE 3b est une représentation schématique d'un exemple de réalisation pour réaliser une étape de détection capacitive discriminante.

En particulier, l'exemple 310 représenté en FIGURE 3b, permet de réaliser une détection capacitive discriminante de la main 102 (qui correspond au premier objet environnant 102) et une détection discriminante du deuxième objet 104.

Pour ce faire, la main 102 est polarisée au potentiel V1, de fréquence F1, différent du potentiel de masse M, délivré par la source électrique 302, comme sur la FIGURE 3a.

L'électrode capacitive 106 est polarisée au potentiel de masse, également comme sur la FIGURE 3a.

Le deuxième objet 104 est, quant à lui, polarisé à un potentiel V2, de fréquence F2, délivré par une source électrique 312, différent du potentiel de masse M et du potentiel V1.

Cet exemple 310 permet de réaliser une étape de détection capacitive discriminante pour détecter, à la fréquence F1, la présence ou l'absence de la main 102. La détection réalisée à la fréquence F1 est une détection en transmission utilisant la main 102 comme électrode émettrice et l'électrode de mesure 106 comme électrode réceptrice.

De plus, cet exemple 310 permet de réaliser une étape détection capacitive discriminante pour détecter, à la fréquence F2, la présence ou l'absence du deuxième objet 104. La détection réalisée à la fréquence F2 est une détection en transmission utilisant le deuxième objet 104 comme électrode émettrice et l'électrode de mesure 106 comme électrode réceptrice.

Dans l'exemple 310 décrit en FIGURE 3b, le même étage d'analyse 120 est utilisé pour la détection capacitive discriminante à la fréquence F1 et la détection capacitive discriminante à la fréquence F2. Alternativement, il est possible d'utiliser deux étages d'analyse, l'un pour la détection capacitive discriminante à F1 et l'autre pour la détection capacitive discriminante à F2.

De plus, les détections discriminantes à F1 et à F2 peuvent être réalisées de manière simultanée ou séquentiellement, à tour de rôle.

Pour réaliser une détection discriminante avec un démodulateur synchrone ou asynchrone, on peut utiliser par exemple des fréquences F2 et F1 différentes. Avec un démodulateur synchrone, on peut également utiliser des potentiels V1 et V2 de même fréquence en quadrature de phase.

Il est à noter que cet exemple 310 permet en outre de réaliser une étape de détection capacitive commune, à savoir une étape de détection, sans discrimination, de l'un quelconque des objets 102 et 104, en imposant des potentiels V1 et V2 identiques ou sensiblement identiques à la fréquence F1 (ou F2). Dans ce cas, les étapes de détections discriminantes et de détection commune peuvent être réalisées séquentiellement, en changeant la configuration d'au moins une source électrique 302, 312.

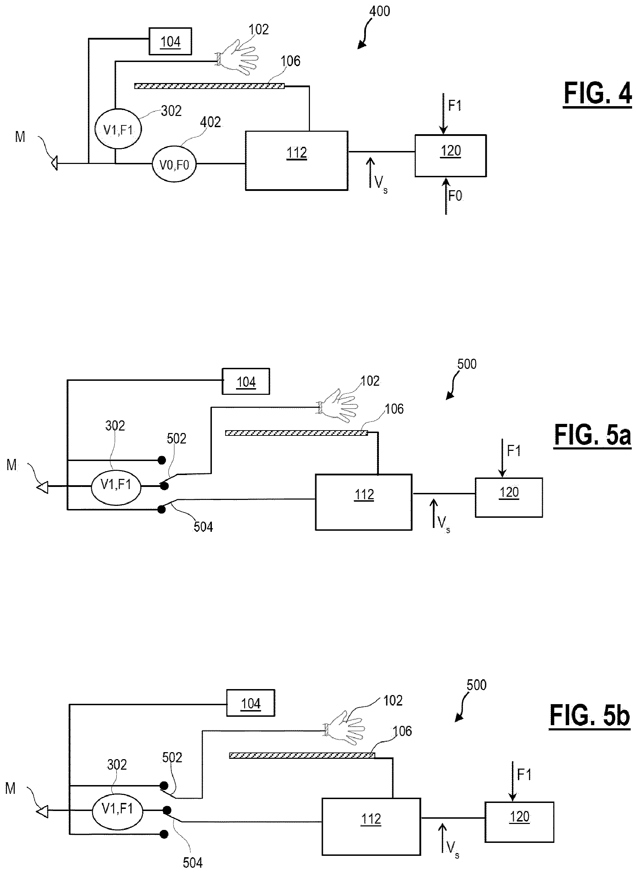

La FIGURE 4 est une représentation schématique d'un exemple de réalisation pour réaliser une étape de détection capacitive discriminante et une étape de détection commune.

En particulier, l'exemple 400 représenté en FIGURE 4, permet de réaliser une détection capacitive discriminante de la main 102 mais aussi une détection commune de l'ensemble des objets environnants sans discrimination.

Pour ce faire, la main 102 (qui correspond au premier objet environnant) est polarisée au potentiel V1, de fréquence F1, différent du potentiel de masse M, délivré par une source électrique 302.

Le deuxième objet 104 est polarisé au potentiel de masse M.

L'électrode de mesure 106 est, quant à elle, polarisée à un potentiel V0, de fréquence F0, délivré par une source 402, différent du potentiel de masse M et du potentiel V1.

Cet exemple 400 permet de réaliser une étape de détection capacitive discriminante pour détecter, à la fréquence F1, la présence ou l'absence de la main 102. La détection réalisée à la fréquence F1 est une détection en transmission utilisant la main comme électrode émettrice et l'électrode de mesure 106 comme électrode réceptrice.

De plus, cet exemple 400 permet de réaliser une étape de détection commune, à F0, permettant de détecter la présence ou l'absence de tout objet environnant sans discrimination. La détection réalisée à la fréquence F0 est une détection en self-capacitance car tout objet environnant, et en particulier les objets 102 et 104, viennent générer une capacité vue par l'électrode de mesure 106 à la fréquence F0.

Comme précédemment, on peut utiliser des fréquences F0 et F1 différentes. Alternativement, avec un démodulateur synchrone, on peut utiliser des potentiels V0 et V1 de même fréquence (F0=F1) en quadrature de phase.

Dans l'exemple décrit en FIGURE 4, le même étage d'analyse 120 est utilisé pour la détection capacitive discriminante à F1 et la détection capacitive commune à F0. Alternativement, il est possible d'utiliser deux étages d'analyse, l'un pour la détection capacitive discriminante à F1 et l'autre pour la détection capacitive commune à F0.

De plus, dans l'exemple 400, les étapes de détection capacitive discriminante et commune peuvent être réalisées simultanément à partir d'un unique signal de mesure fourni par l'étage de mesure 112.

Dans l'exemple décrit en FIGURE 4 au moins deux sources électriques sont utilisées pour réaliser une étape de détection capacitive discriminante et une étape de détection capacitive commune.

Il est également possible d'utiliser une seule source électrique pour réaliser ces deux étapes de détection capacitives, de manière séquentielle.

Les FIGURES 5a et 5b sont des représentations schématiques, dans deux configurations, d'un exemple permettant de réaliser une étape de détection capacitive discriminante et une étape de détection commune, avec une seule source électrique

En particulier, la FIGURE 5a représente la configuration permettant de réaliser une détection capacitive discriminante de la main 102 individuellement, et la FIGURE 5b représente la configuration permettant de réaliser une détection capacitive commune de tout objet sans discrimination, y compris la main 102.

Dans l'exemple représenté sur les FIGURES 5a et 5b, une unique source électrique est utilisée, à savoir la source électrique 302 délivrant le potentiel alternatif V1, à la fréquence F1.

Un premier commutateur 502 est utilisé pour relier la main 102, sélectivement soit au potentiel de masse M, soit au potentiel V1 délivré par la source 302.

Un deuxième commutateur 504 est utilisé pour relier l'électrode de mesure 106, sélectivement soit au potentiel de masse M, soit au potentiel V1 délivré par la source 302.

Quel que soit la configuration, le deuxième objet 104 est polarisé au potentiel de masse électrique M.

Dans la configuration représentée sur la FIGURE 5a, la main est reliée à la source 302 par le commutateur 502 : la main est donc polarisée au potentiel V1. En même temps, l'électrode de mesure 106 est reliée au potentiel de masse M par le commutateur 504 : l'électrode de mesure 106 est donc polarisée au potentiel de masse M. Cette configuration, permet de réaliser une étape détection capacitive discriminante pour détecter, à la fréquence F1, la présence ou l'absence de la main 102 individuellement. La détection réalisée à la fréquence F1 est une détection en transmission utilisant la main 102 comme électrode émettrice et l'électrode de mesure 106 comme électrode réceptrice.

Dans la configuration représentée sur la FIGURE 5b, la main est reliée au potentiel de masse M par le commutateur 502 : la main 102 est donc polarisée au potentiel de masse M. En même temps, l'électrode de mesure 106 est reliée à la source 302 par le commutateur 504 : l'électrode de mesure 106 est donc polarisée au potentiel V1. Cette configuration, permet de réaliser une étape détection capacitive commune détectant la présence ou non de tout objet environnant, et en particulier la présence ou l'absence de la main 102 et/ou du deuxième objet 104, tous deux polarisés au potentiel de masse M. La détection, réalisée à la fréquence F1, est une détection en self capacitance.

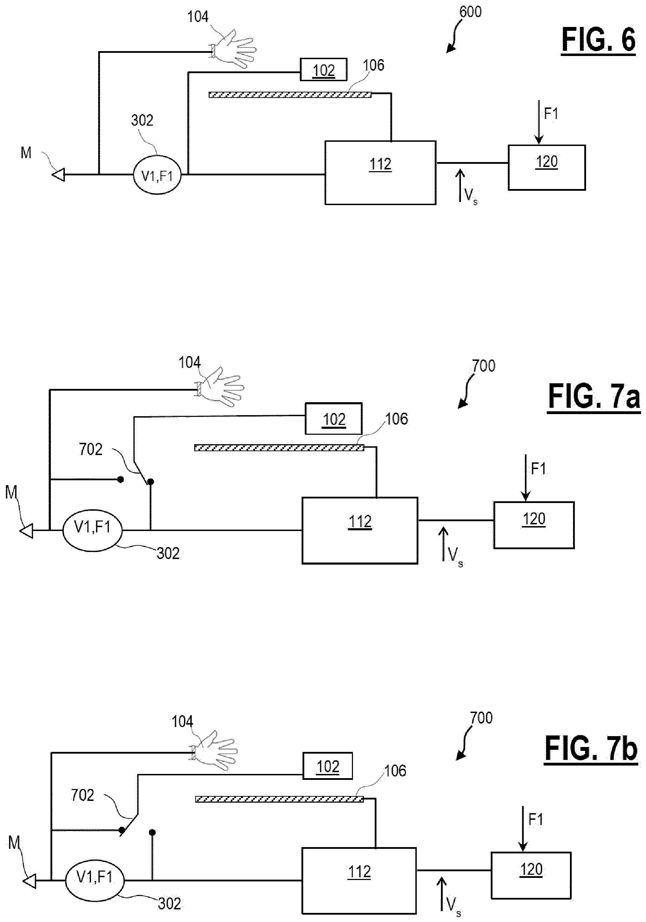

Nous allons maintenant décrire d'autres exemples de réalisation particuliers, en référence aux FIGURES 6 à 7b. Sur ces FIGURES, et de manière nullement limitative, on considère que le deuxième objet environnant 104 est une main d'un opérateur et le premier objet environnant 102 est tout autre objet pouvant se trouver dans l'environnement de l'équipement, qui est dans le cas illustré un robot, tel qu'une table, un support, un autre robot, etc. En particulier, le premier objet peut être un plan de travail sur lequel le robot effectue des opérations.

La FIGURE 6 est une représentation schématique d'un exemple de réalisation pour réaliser une étape de détection capacitive discriminante.

L'exemple 600, représenté en FIGURE 6, permet de réaliser une détection capacitive discriminante de la main 104 (qui correspond au deuxième objet environnant).

Pour ce faire, la main 104 est polarisée au potentiel de masse M. Le premier objet 102 et l'électrode capacitive 106 sont polarisés au potentiel V1, de fréquence F1, différent du potentiel de masse M à ladite fréquence F1, délivré par la source électrique 302.

Dans ces conditions, le premier objet 102 est électriquement invisible pour l'électrode de mesure 106 car il est au même potentiel que l'électrode de mesure 106.

Cet exemple 600 permet de réaliser une étape détection capacitive discriminante pour détecter, à la fréquence F1, la présence ou l'absence de la main 104, qui étant à la masse vient modifier la capacité vue par l'électrode de mesure 106. La détection réalisée est une détection en self capacitance.

Cet exemple 600 ne permet, par contre, pas de réaliser une étape de détection capacitive commune.

Les FIGURES 7a et 7b sont des représentations schématiques, dans deux configurations, d'un exemple permettant de réaliser une étape de détection capacitive discriminante et une étape de détection capacitive commune, avec une seule source électrique.

En particulier, la FIGURE 7a représente la configuration permettant de réaliser une détection capacitive discriminante de la main 104 individuellement, et la FIGURE 7b représente la configuration permettant de réaliser une détection capacitive commune de tout objet sans discrimination, y compris la main 104.

Dans l'exemple représenté sur les FIGURES 7a et 7b, une unique source électrique est utilisée, à savoir la source électrique 302 délivrant le potentiel alternatif V1, à la fréquence F1.

Quel que soit la configuration, la main 104 (qui correspond au deuxième objet 104) est reliée au potentiel de masse électrique M.

Quel que soit la configuration, l'électrode de mesure 106 est polarisée au potentiel V1 délivré par la source 302.

Un commutateur 702 est utilisé pour modifier la polarisation du premier objet 102 entre la configuration représentée sur la FIGURE 7a et la configuration représentée sur la FIGURE 7b. En particulier, le commutateur 702 relie le premier objet, sélectivement soit au potentiel V1 délivré par la source 302 soit au potentiel de masse M.

Dans la configuration représentée sur la FIGURE 7a, le premier objet 102 est relié à la source 302 par le commutateur 702 : le premier objet 102 est donc polarisé au potentiel V1 comme l'électrode de mesure 106. Le premier objet est donc électriquement invisible de l'électrode de mesure 106 à la fréquence F1 de V1. Cette configuration permet de réaliser une étape détection capacitive discriminante pour détecter, à la fréquence F1, la présence ou l'absence de la main 104 individuellement. La détection réalisée à la fréquence F1 est une détection en self-capacitance car la main polarisée au potentiel de masse M vient modifier la capacité vue par l'électrode de mesure 106.

Dans la configuration représentée sur la FIGURE 7b, le premier objet est relié au potentiel de masse M par le commutateur 702 : le premier objet 102 est donc polarisée au potentiel de masse M comme la main 104. Cette configuration permet de réaliser, à la fréquence F1, une étape de détection capacitive commune détectant la présence ou non de tout objet environnant, et en particulier la présence ou l'absence du premier objet 102 et/ou de la main 104, tous deux polarisés au potentiel de masse M. La détection réalisée à la fréquence F1 est une détection en self capacitance.

## Revendications

1. Procédé de détection capacitive d'objets environnants (102,104) pouvant se trouver dans l'environnement d'un équipement pourvu d'un dispositif de détection capacitive (100) comprenant :
- au moins une électrode capacitive (106), dite de mesure ; et
- une électronique de détection (110) pour polariser l'au moins une électrode de mesure (106) à un potentiel électrique, et mesurer au moins un signal (Vₛ) représentatif d'une capacité, dite électrode-objet, vue par ladite au moins une électrode de mesure (106) ;
ledit procédé comprenant une étape, dite de détection discriminante, de détection sélective d'un objet environnant (102,104), comprenant l'opération suivante : :
- polarisation d'un premier objet environnant (102) à un premier potentiel électrique alternatif (V1), différent d'un potentiel de masse (M), et différent d'un potentiel électrique d'au moins un deuxième objet environnant (104), au moins à une première fréquence (F1) ;
ledit procédé étant **caractérisé en ce que** l'étape de détection discriminante comprend en outre l'opération suivante :
- détermination d'un premier signal discriminant représentatif d'une capacité, dite capacité électrode-objet, vue par ladite au moins une électrode de mesure, à ladite première fréquence (F1).

2. Procédé selon la revendication précédente, **caractérisé en ce qu'**il comprend, pendant l'étape de détection discriminante, une polarisation d'au moins un deuxième objet (104) au potentiel de masse (M).

3. Procédé selon l'une quelconque des revendications précédentes, **caractérisé en ce qu'**il comprend, pendant l'étape de détection discriminante, une polarisation d'au moins un deuxième objet (104) à un deuxième potentiel alternatif (V2) à une deuxième fréquence (F2) différente de la première fréquence (F1).

4. Procédé selon l'une quelconque des revendications précédentes, **caractérisé en ce qu'**il comprend, pendant l'étape de détection discriminante, une polarisation d'au moins un deuxième objet (104) à un potentiel de même fréquence que le premier potentiel alternatif (V1) et orthogonal audit premier potentiel alternatif (V1), à la première fréquence (F1).

5. Procédé selon l'une quelconque des revendications précédentes, **caractérisé en ce que**, pendant l'étape de détection discriminante, l'au moins une électrode de mesure (106) est polarisée au potentiel de masse (M).

6. Procédé selon l'une quelconque des revendications 1 à 4, **caractérisé en ce que**, pendant l'étape de détection discriminante, l'au moins une électrode de mesure (106) est polarisée à un troisième potentiel alternatif.

7. Procédé selon la revendication 6, **caractérisé en ce que**, pendant l'étape de détection discriminante, le troisième potentiel de polarisation (V0) est :
- différent du premier potentiel (V1) de polarisation à la première fréquence (F1), et
- le cas échéant, différent du deuxième potentiel (V2) de polarisation à la deuxième fréquence (F1).

8. Procédé selon la revendication 6, **caractérisé en ce que** le troisième potentiel est identique au premier potentiel de polarisation (V1) à la première fréquence (F1), ou au deuxième potentiel de polarisation (V2) à la deuxième fréquence (F2).

9. Procédé selon l'une quelconque des revendications précédentes, **caractérisé en ce qu'**il comprend en outre une étape, dite de détection commune, de détection des objets environnants (102,104), comprenant les opérations suivantes :
- polarisation d'au moins une électrode de mesure à un potentiel alternatif, dit de travail, différent d'un potentiel de masse (M), et différent des potentiels des premier et deuxième objets environnants au moins à une fréquence, dite de travail ; et
- détermination d'un signal commun, représentatif d'une capacité, dite capacité électrode-objet, vue par l'au moins une électrode de mesure, à ladite fréquence de travail.

10. Procédé selon la revendication 9, **caractérisé en ce que** lors de l'étape de détection commune :
- la fréquence de travail est identique à la première fréquence (F1), et le potentiel de travail est identique, à cette fréquence (F1), au premier potentiel de polarisation (V1) d'un premier objet (102) lors de l'étape de détection discriminante, ou
- le cas échéant, la fréquence de travail est identique à la deuxième fréquence et le potentiel de travail est identique, à cette fréquence, au deuxième potentiel de polarisation (V2) d'un deuxième objet (104) ;
les étapes de détection discriminante et commune étant réalisées de manière séquentielle, ledit procédé comprenant une étape de modification du potentiel dudit premier objet (102), ou dudit deuxième objet (104), entre lesdites étapes de détection.

11. Procédé selon la revendication 9, **caractérisé en ce que**, le potentiel de travail (V0) utilisé lors de l'étape de détection commune, est différent :
- des potentiels de polarisation (V1,M) des objets (102,104) utilisés lors de l'étape de détection discriminante, à la première fréquence (F1) ; et
- le cas échéant, du deuxième potentiel à la deuxième fréquence ;
les étapes de détection discriminante et de détection commune étant réalisées de manière simultanée de sorte que le signal de détection commune et le(s) signal(signaux) de détection discriminante, sont déterminés à partir d'un même signal mesuré.

12. Procédé selon l'une quelconque des revendications précédentes, **caractérisé en ce qu'**au moins un objet environnant (102,104) est polarisé de manière filaire à partir d'une source électrique (302) alimentant le dispositif de détection.

13. Procédé selon l'une quelconque des revendications précédentes, **caractérisé en ce qu'**au moins un objet environnant (102,104) est polarisé par une source électrique indépendante (302) d'une source électrique (402) alimentant le dispositif de détection (100), ledit procédé comprenant en outre un échange, entre lesdites sources, d'un signal sans fil pour :
- synchroniser lesdites sources (302,402) entre-elles ; ou
- récupérer la fréquence, et/ou la phase, du signal de polarisation dudit au moins un objet environnant (102).

14. Procédé selon l'une quelconque des revendications précédentes, **caractérisé en ce que** le premier objet (102) est au moins une partie d'un corps d'un opérateur humain, et en particulier une main ou un bras dudit opérateur.

15. Procédé selon l'une quelconque des revendications précédentes, **caractérisé en ce que** le premier objet (102) est une surface de travail faisant face à l'équipement telle qu'une table, un plan de travail, un tapis roulant, et le deuxième objet (104) est au moins une partie d'un corps d'un opérateur humain.

16. Dispositif de détection capacitive (200;300;310;400;500;600;700), pour un équipement, comprenant :
- au moins une électrode capacitive (106), dite de mesure ; et
- une électronique de détection (110) pour polariser au moins une électrode de mesure (106), et mesurer au moins un signal représentatif d'une capacité, dite électrode-objet, vue par ladite au moins une électrode de mesure (106) ; et
- un moyen de polarisation d'au moins un objet environnant (102,104) ;
agencés pour mettre en oeuvre toutes les étapes du procédé selon l'une quelconque des revendications précédentes.

17. Dispositif (400) selon la revendication précédente, **caractérisé en ce qu'**il comprend :
- une première source électrique (302) pour polariser le premier objet (104) ; et
- une deuxième source pour alimenter l'électronique de détection (100), indépendante de ladite première source.

18. Dispositif (500;700) selon la revendication 16, **caractérisé en ce qu'**il comprend une unique source électrique (302) pour la polarisation, à tour de rôle :
- d'au moins un objet environnant (102;104), et
- des électrodes de mesure (106) ;
ledit dispositif (500) comprenant en outre des moyens de connexion/déconnexion à tour de rôle de ladite source audit objet environnant et auxdites électrodes de mesure.

19. Équipement pourvu d'un dispositif de détection capacitive selon l'une quelconque des revendications 16 à 18.

20. Équipement selon la revendication précédente, **caractérisé en ce qu'**il est de type robot.

## Patentansprüche

1. Verfahren zur kapazitiven Erkennung von Umgebungsobjekten (102, 104), die sich in der Umgebung einer Ausrüstung befinden können, die mit einer Vorrichtung (100) zur kapazitiven Erkennung versehen ist, umfassend:
- mindestens eine sogenannte kapazitive Messelektrode (106); und
- eine Erkennungselektronik (110) zum Polarisieren der mindestens einen Messelektrode (106) auf ein elektrisches Potential und Messen mindestens eines Signals (Vₛ), das für eine sogenannte Objektelektrodenkapazität repräsentativ ist, die von der mindestens einen Messelektrode (106) festgestellt wird;
wobei das Verfahren einen sogenannten Schritt des unterscheidenden Erkennens zum selektiven Erkennen eines Umgebungsobjekts (102, 104) umfasst, der den folgenden Vorgang umfasst:
- Polarisieren eines ersten Umgebungsobjekts (102) auf ein erstes elektrisches Wechselpotential (V1), das sich von einem Massepotential (M) unterscheidet und sich von einem elektrischen Potential von mindestens einem zweiten Umgebungsobjekt (104) unterscheidet, bei mindestens einer ersten Frequenz (F1);
wobei das Verfahren **dadurch gekennzeichnet ist, dass** der Schritt des unterscheidenden Erkennens ferner den folgenden Vorgang umfasst:
- Bestimmen eines ersten unterscheidenden Signals, das für eine sogenannte Objektelektrodenkapazität repräsentativ ist, die von der mindestens einen Messelektrode festgestellt wird, bei der ersten Frequenz (F1).

2. Verfahren nach dem vorhergehenden Anspruch, **dadurch gekennzeichnet, dass** es während des Schritts des unterscheidenden Erkennens eine Polarisation mindestens eines zweiten Objekts (104) auf das Massepotential (M) umfasst.

3. Verfahren nach einem der vorhergehenden Ansprüche, **dadurch gekennzeichnet, dass** es während des Schritts des unterscheidenden Erkennens eine Polarisation von mindestens einem zweiten Objekt (104) auf ein zweites Wechselpotential (V2) bei einer zweiten Frequenz (F2) umfasst, die sich von der ersten Frequenz (F1) unterscheidet.

4. Verfahren nach einem der vorhergehenden Ansprüche, **dadurch gekennzeichnet, dass** es während des Schritts des unterscheidenden Erkennens eine Polarisation von mindestens einem zweiten Objekt (104) auf ein Potential mit der gleichen Frequenz wie das erste Wechselpotential (V1) und orthogonal zu dem ersten Wechselpotential (V1) bei der ersten Frequenz (F1) umfasst.

5. Verfahren nach einem der vorhergehenden Ansprüche, **dadurch gekennzeichnet, dass** während des Schritts des unterscheidenden Erkennens die mindestens eine Messelektrode (106) auf das Massepotential (M) polarisiert wird.

6. Verfahren nach einem der Ansprüche 1 bis 4, **dadurch gekennzeichnet, dass** während des Schritts des unterscheidenden Erkennens die mindestens eine Messelektrode (106) auf ein drittes Wechselpotential polarisiert wird.

7. Verfahren nach Anspruch 6, **dadurch gekennzeichnet, dass** während des Schritts des unterscheidenden Erkennens das dritte Polarisationspotential (V0) Folgendes ist:
- unterschiedlich vom ersten Polarisationspotential (V1) bei der ersten Frequenz (F1), und
- gegebenenfalls unterschiedlich vom zweiten Polarisationspotential (V2) bei der zweiten Frequenz (F1) .

8. Verfahren nach Anspruch 6, **dadurch gekennzeichnet, dass** das dritte Potential identisch mit dem ersten Polarisationspotential (V1) bei der ersten Frequenz (F1) oder mit dem zweiten Polarisationspotential (V2) bei der zweiten Frequenz (F2) ist.

9. Verfahren nach einem der vorhergehenden Ansprüche, **dadurch gekennzeichnet, dass** es ferner einen sogenannten Schritt des gemeinsamen Erkennens zum Erkennen der Umgebungsobjekte (102, 104) umfasst, der die folgenden Vorgänge umfasst:
- Polarisieren mindestens einer Messelektrode auf ein sogenanntes Arbeitswechselpotential, das sich von einem Massepotential (M) unterscheidet und sich von den Potentialen des ersten und des zweiten Umgebungsobjekts bei mindestens einer sogenannten Arbeitsfrequenz unterscheidet; und
- Bestimmen eines gemeinsamen Signals, das für eine sogenannte Objektelektrodenkapazität repräsentativ ist, die von der mindestens einen Messelektrode festgestellt wird, bei der Arbeitsfrequenz.

10. Verfahren nach Anspruch 9, **dadurch gekennzeichnet, dass** beim Schritt des gemeinsamen Erkennens:
- die Arbeitsfrequenz identisch mit der ersten Frequenz (F1) ist und das Arbeitspotential bei dieser Frequenz (F1) identisch mit dem ersten Polarisationspotential (V1) eines ersten Objekts (102) beim Schritt des unterscheidenden Erkennens ist, oder
- gegebenenfalls die Arbeitsfrequenz identisch mit der zweiten Frequenz ist und das Arbeitspotential bei dieser Frequenz identisch mit dem zweiten Polarisationspotential (V2) eines zweiten Objekts (104) ist;
wobei die Schritte des unterscheidenden und gemeinsamen Erkennens auf aufeinanderfolgende Weise ausgeführt werden, wobei das Verfahren einen Schritt des Änderns des Potentials des ersten Objekts (102) oder des zweiten Objekts (104) zwischen den Erkennungsschritten umfasst.

11. Verfahren nach Anspruch 9, **dadurch gekennzeichnet, dass** das beim Schritt des gemeinsamen Erkennens verwendete Arbeitspotential (V0) sich unterscheidet:
- von den beim Schritt des unterscheidenden Erkennens verwendeten Polarisationspotentialen (V1, M) der Objekte (102, 104) bei der ersten Frequenz (F1); und
- gegebenenfalls vom zweiten Potential bei der zweiten Frequenz;
wobei die Schritte des unterscheidenden Erkennens und des gemeinsamen Erkennens gleichzeitig ausgeführt werden, sodass das gemeinsame Erkennungssignal und das/die unterscheidende/n Erkennungssignal/e ausgehend von einem gleichen gemessenen Signal bestimmt werden.

12. Verfahren nach einem der vorhergehenden Ansprüche, **dadurch gekennzeichnet, dass** mindestens ein Umgebungsobjekt (102, 104) ausgehend von einer Stromquelle (302), welche die Erkennungsvorrichtung mit Strom versorgt, drahtgebunden polarisiert wird.

13. Verfahren nach einem der vorhergehenden Ansprüche, **dadurch gekennzeichnet, dass** mindestens ein Umgebungsobjekt (102, 104) durch eine Stromquelle (302) polarisiert wird, die unabhängig von einer Stromquelle (402) ist, welche die Erkennungsvorrichtung (100) mit Strom versorgt, wobei das Verfahren ferner einen Austausch eines drahtlosen Signals zwischen den Quellen umfasst zum:
- Synchronisieren der Quellen (302, 402) untereinander; oder
- Wiedergewinnen der Frequenz und/oder der Phase des Polarisationssignals des mindestens einen Umgebungsobjekts (102).

14. Verfahren nach einem der vorhergehenden Ansprüche, **dadurch gekennzeichnet, dass** das erste Objekt (102) zumindest teilweise ein Teil eines Körpers eines menschlichen Bedieners, insbesondere eine Hand oder ein Arm des Bedieners, ist.

15. Verfahren nach einem der vorhergehenden Ansprüche, **dadurch gekennzeichnet, dass** das erste Objekt (102) eine Arbeitsfläche ist, die der Ausrüstung zugewandt ist, wie beispielsweise ein Tisch, eine Arbeitsebene, ein Laufband, und das zweite Objekt (104) mindestens ein Teil eines Körpers eines menschlichen Bedieners ist.

16. Vorrichtung (200; 300; 310; 400; 500; 600; 700) zur kapazitiven Erkennung für eine Ausrüstung, umfassend:
- mindestens eine sogenannte kapazitive Messelektrode (106); und
- eine Erkennungselektronik (110) zum Polarisieren mindestens einer Messelektrode (106) und Messen mindestens eines Signals, das für eine sogenannte Objektelektrodenkapazität repräsentativ ist, die von der mindestens einen Messelektrode (106) festgestellt wird; und
- ein Mittel zur Polarisation mindestens eines Umgebungsobjekts (102, 104);
die gestaltet sind, um sämtliche Schritte des Verfahrens nach einem der vorhergehenden Ansprüche durchzuführen.

17. Vorrichtung (400) nach dem vorhergehenden Anspruch, **dadurch gekennzeichnet, dass** es Folgendes umfasst:
- eine erste Stromquelle (302) zum Polarisieren des ersten Objekts (104); und
- eine zweite Stromquelle zum Versorgen der Erkennungselektronik (100) mit Strom, die unabhängig von der ersten Quelle ist.

18. Vorrichtung (500; 700) nach Anspruch 16, **dadurch gekennzeichnet, dass** es eine einzige Stromquelle (302) zur turnusmäßigen Polarisation umfasst:
- mindestens eines Umgebungsobjekts (102; 104), und
- der Messelektroden (106);
wobei die Vorrichtung (500) ferner Mittel zur turnusmäßigen Verbindung/Trennung der Quelle mit/von dem Umgebungsobjekt und mit/von den Messelektroden umfasst.

19. Ausrüstung, die mit einer Vorrichtung zur kapazitiven Erkennung nach einem der Ansprüche 16 bis 18 versehen ist.

20. Ausrüstung nach dem vorhergehenden Anspruch, **dadurch gekennzeichnet, dass** sie vom Typ Roboter ist.

## Claims

1. A method for capacitive detection of nearby objects (102,104) that may be located in the environment of an equipment equipped with a capacitive detection device (100) comprising:
- at least one capacitive electrode (106), called measurement electrode; and
- detection electronics (110) for polarizing the at least one measurement electrode (106) at an electrical potential, and measuring at least one signal (Vₛ) representative of a capacitance, called electrode-object capacitance, seen by said at least one measurement electrode (106);
said method comprising a step, called discriminative detection step, of selective detection of a nearby object (102, 104), comprising the following operation:
- polarizing a first nearby object (102) at a first alternating electrical potential (V1), different from a ground potential (M), and different from an electrical potential of at least one second nearby object (104), at least at a first frequency (F1);
said method being **characterized in that** the discriminative detection step further comprises the following operation:
- determining a first discriminative signal representative of a capacitance, called electrode-object capacitance, seen by said at least one measurement electrode, at said first frequency (F1).

2. The method according to the preceding claim, **characterized in that** it comprises, during the discriminative detection step, polarizing at least one second object (104) at the ground potential (M).

3. The method according to any one of the preceding claims, **characterized in that** it comprises, during the discriminative detection step, polarizing at least one second object (104) at a second alternating potential (V2) at a second frequency (F2) different from the first frequency (F1).

4. The method according to any one of the preceding claims, **characterized in that** it comprises, during the discriminative detection step, polarizing at least one second object (104) at a potential of the same frequency as the first alternating potential (V1) and orthogonal to said first alternating potential (V1), at the first frequency (F1).

5. The method according to any one of the preceding claims, **characterized in that**, during the discriminative detection step, the at least one measurement electrode (106) is polarized at the ground potential (M).

6. The method according to any one of claims 1 to 4, **characterized in that**, during the discriminative detection step, the at least one measurement electrode (106) is polarized at a third alternating potential.

7. The method according to claim 6, **characterized in that**, during the discriminative detection step, the third polarization potential (V0) is:
- different from the first polarization potential (V1) at the first frequency (F1), and
- if applicable, different from the second polarization potential (V2) at the second frequency (F1).

8. The method according to claim 6, **characterized in that** the third potential is identical to the first polarization potential (V1) at the first frequency (F1), or to the second polarization potential (V2) at the second frequency (F2).

9. The method according to any one of the preceding claims, **characterized in that** it also comprises a step, called common detection step, of detection of the nearby objects (102, 104), comprising the following operations:
- polarizing at least one measurement electrode at an alternating potential, called working potential, different from a ground potential (M), and different from the potentials of the first and second nearby objects at a frequency, called working frequency; and
- determining a common signal representative of a capacitance, called electrode-object capacitance, seen by the at least one measurement electrode, at said working frequency.

10. The method according to claim 9, **characterized in that**, during the common detection step:
- the working frequency is identical to the first frequency (F1), and the working potential is identical, at this frequency (F1), to the first polarization potential (V1) of a first object (102) during the discriminative detection step, or
- if applicable, the working frequency is identical to the second frequency and the working potential is identical, at this frequency, to the second polarization potential (V2) of a second object (104);
the steps of discriminative and common detection being carried out sequentially, said method comprising a step of modifying the potential of said first object (102), or of said second object (104), between said detection steps.

11. The method according to claim 9, **characterized in that** the working potential (V0) used during the common detection step, is different:
- from the polarization potentials (V1, M) of the objects (102, 104) used during the discriminative detection step, at the first frequency (F1); and
- if applicable, from the second potential at the second frequency;
the steps of discriminative detection and common detection being carried out simultaneously so that the common detection signal and the discriminative detection signal(s) are determined from one and the same measured signal.

12. The method according to any one of the preceding claims, **characterized in that** at least one nearby object (102, 104) is polarized in a wired manner from an electrical source (302) supplying the detection device.

13. The method according to any one of the preceding claims, **characterized in that** at least one nearby object (102, 104) is polarized by an electrical source (302) independent of an electrical source (402) supplying the detection device (100), said method also comprising an exchange, between said sources, of a wireless signal for:
- synchronizing said sources (302, 402) with one another; or
- recovering the frequency, and/or the phase, of the polarization signal of said at least one nearby object (102).

14. The method according to any one of the preceding claims, **characterized in that** the first object (102) is at least one part of a body of a human operator, and in particular a hand or an arm of said operator.

15. The method according to any one of the preceding claims, **characterized in that** the first object (102) is a working area facing the equipment such as a table, a worktop, a belt conveyor, and the second object (104) is at least one part of a body of a human operator.

16. A capacitive detection device (200; 300; 310; 400; 500; 600; 700) for an equipment, comprising:
- at least one capacitive electrode (106), called measurement electrode, and
- a detection electronics (110) for polarizing at least one measurement electrode (106), and measuring at least one signal representative of a capacitance, called electrode-object capacitance, seen by said at least one measurement electrode (106); and
- a means for polarizing at least one nearby object (102, 104);
arranged in order to implement all of the steps of the method according to any one of the preceding claims.

17. The device (400) according to the preceding claim, **characterized in that** it comprises:
- a first electrical source (302) for polarizing the first object (104); and
- a second source for supplying the detection electronics (100), independent of said first source.

18. The device (500; 700) according to claim 16, **characterized in that** it comprises a single electrical source (302) for polarizing, in turn:
- at least one nearby object (102; 104), and
- measurement electrodes (106);
said device (500) also comprising means for connecting/disconnecting said source in turn to/from said nearby object and said measurement electrodes.

19. An equipment equipped with a capacitive detection device according to any one of claims 16 to 18.

20. The equipment according to the preceding claim, **characterized in that** it is of the robot type.
